# EUROPÄISCHE PATENTSCHRIFT

(11) **EP 3 387 677 B1**
(45) Veröffentlichungstag und Bekanntmachung des Hinweises auf die Patenterteilung: **07.12.2022**
(21) Anmeldenummer: 16784179.0
(22) Anmeldetag: 19.10.2016
(51) Int. Cl.: H01L 29/78, H01L 29/06

(54) **HALBLEITERTRANSISTOR MIT SUPERLATTICE-STRUKTUREN**
SEMICONDUCTOR TRANSISTOR COMPRISING SUPERLATTICE STRUCTURES
TRANSISTOR À SEMI-CONDUCTEUR AYANT DES STRUCTURES À SUPER-RÉSEAU

(30) Priorität: 11.12.2015 DE 102015224965
(43) Veröffentlichungstag der Anmeldung: 17.10.2018
(73) Patentinhaber: Robert Bosch GmbH, 70442 Stuttgart (DE)
(72) Erfinder: JACKE, Thomas, 72070 Tuebingen (DE); GRIEB, Michael, 71272 Renningen-Malmsheim (DE); BANZHAF, Christian Tobias, 89150 Laichingen (DE); RAMBACH, Martin, 72124 Pliezhausen (DE)
(86) Internationale Anmeldenummer: PCT/EP2016/075034
(87) Internationale Veröffentlichungsnummer: WO 2017/097482

(56) Entgegenhaltungen:
- EP-A1- 2 863 417
- WO-A1-2015/012009
- DE-T5-112011 104 322
- US-A- 6 049 108
- US-A1- 2009 152 667
- US-A1- 2013 270 576

## Beschreibung

Die vorliegende Erfindung betrifft einen Transistor, der über eine Vielzahl von Trenches verfügt, in denen sich die Gate-Elektrode befindet und untereinander verbundene Abschirmgebiete aufweist zur Verhinderung von hohen elektrischen Feldern.

### Stand der Technik

Nach derzeitigem Stand der Technik werden Leistungstransistoren durch eine Parallelschaltung von Einzelzellen im Zellfeld hergestellt. Diese Einzelzellen sind alle identisch, um einen sicheren Parallelbetrieb zu gewährleisten. Lediglich im Randbereich des Transistors, das heißt zwischen Zellfeld und Randstruktur beziehungsweise zwischen Zellfeld und Gateanschluss/Gaterunner, kommen derzeit teilweise abgeänderte Zellstrukturen zum Einsatz. Die Anzahl der stromtragenden Einzelzellen für einen Leistungstransistor beträgt derzeit mehrere Tausend.

Häufig kommen dabei TrenchMOSFETs zum Einsatz, die typischerweise geringe Durchlasswiderstände und daher geringe Durchlassverluste aufweisen. Bei TrenchMOSFETs befindet sich innerhalb der Trenches eine Gate-Elektrode, die durch einen Gate-Isolator, meist ein Gateoxid, von der Umgebung isoliert wird. Bei TrenchMOSFETs ist dabei sicherzustellen, dass die elektrische Feldstärke am Gateoxid innerhalb gewisser Schranken bleiben soll, da sonst unerwünschte Leckströme oder gar die Zerstörung des Gateoxids die Folge sind.

Um einen sicheren Betrieb zu gewährleisten, hat man Lösungen gefunden, die darauf abzielen, das elektrische Feld in der Nähe der Trenches mittels p-dotierter oder effektiv p-dotierter Gebiete zu reduzieren (bei npn-Schichtfolge), zum Beispiel mittels sogenannter p-bubbles. In Takaye et al., Proceedings of the 19th

International Symposium on Power Semiconductor Devices & ICs, p.197-200 (2007) sind solche p-Gebiete für einen auf Silicium basierenden TrenchMOSFET unterhalb der Gate-Trenches eingebracht, jedoch floatend ausgeführt, das heißt, die p-Gebiete haben kein definiertes Spannungspotential.

In Nakamura et al., 2011 IEEE International Electron Devices Meeting, p. 26.5.1-26.5.3 (2011) wird ein auf Siliciumcarbid (SiC) basierender TrenchMOSFET vorgestellt, bei dem die p-Gebiete zur Feldabschirmung neben dem Trench angeordnet sind und im Gegensatz zu Takaya et al., Proceedings of the 19th International Symposium on Power Semiconductor Devices & ICs, p.197-200 (2007) mithilfe einer Metallisierung an das Source-Potential angeschlossen sind. Dieser Anschluss ist für Bauelemente basierend auf Siliciumcarbid (SiC) zwingend erforderlich, da ansonsten aufgrund der um Größenordnungen geringeren Minoritätsladungsträgerkonzentration im Vergleich zu Silicium (Si) ein Wiederbefüllen solcher p-Gebiete nach deren Ausräumung sehr lange dauert und damit das Schaltverhalten deutlich verschlechtert wird.

Eine weitere Möglichkeit für eine Realisierung eines SiC-TrenchMOSFETs ist in der EP 2 091 083 A2 dargelegt (Figur 1). Hierbei werden die p-Gebiete zur Feldabschirmung orthogonal zu den Trench-Linien geführt. Die Kontaktierung erfolgt wie bei Takaya et al., Proceedings of the 19th International Symposium on Power Semiconductor Devices & ICs, p. 197-200 (2007) unmittelbar an jedem Trench. Eine weitere Variante ist beispielsweise in der US 2011/0121316 A1 offenbart (Fig.1). Dabei liegen die p-Gebiete zur Abschirmung des elektrischen Feldes ähnlich wie bei Takaya et al., Proceedings of the 19th International Symposium on Power Semiconductor Devices & ICs, p. 197-200 (2007) neben den Gate-Trenches. Die Kontaktierung dieser p-Bereiche erfolgt ebenfalls in jeder Zelle.

Den obengenannten Ausführungsformen des Standes der Technik ist gemeinsam, dass die kontaktierten p-Gebiete zur Abschirmung des elektrischen Feldes vollständig oder teilweise neben dem Gate-Trench liegen. Dabei sind die Kontakte der p-Gebiete stets an Ort und Stelle ausgeführt. Dadurch entsteht ein zusätzlicher Flächenbedarf für die Zellstruktur, der keine weitere Kanalweitenerhöhung mit sich bringt. Dadurch wird das Pitch-Maß des Transistors erhöht.

Der notwendige Flächenbedarf für diese p-Gebiete und für die Kontaktierung der p-Gebiete in jeder Einzelzelle summiert sich dabei entsprechend mit der Zahl der Zellen (mehrere Tausend pro Transistor) auf.

In der DE 11 2011 104322 T5 wird eine Halbleitervorrichtung vom Trench-Gate-Typ angegeben, welche einen Durchschlag durch eine Gate-Isolierschicht verhindern kann, der zu einem Ausschaltzeitpunkt durch einen Verschiebungsstrom verursacht wird, der in eine Schutz-Diffusionsschicht in einem Bereich eines unterhalb der Gate-Elektrode liegenden Grabens hineinfließt, wobei die Halbleitervorrichtung gleichzeitig die Stromdichte verbessert, indem der Zellenabstand schmaler gemacht wird. Ein Schutzkontakt zum Verbinden der Schutz-Diffusionsschicht in einem unteren Bereich des Grabens mit einer Source-Elektrode ist auf dem Schutzkontaktbereich ausgebildet. Eine entsprechende Halbleitervorrichtung ist auch bereits aus der WO 2015/012009 A1 bekannt.

### Offenbarung der Erfindung

Erfindungsgemäß wird ein Transistor zur Verfügung gestellt, umfassend ein Substrat eines ersten Dotierungstyps, eine Epitaxieschicht des ersten Dotierungstyps oberhalb des Substrats, eine Kanalschicht eines zweiten, vom ersten verschiedenen Dotierungstyps oberhalb der Epitaxieschicht, eine Vielzahl von sich bis in die Epitaxieschicht erstreckenden Trenches in der Kanalschicht, die Jeweils eine innerhalb der Trenches befindliche Gate-Elektrode aufweisen und von einem Source-Anschluss des ersten Dotierungstyps oberhalb der Kanalschicht umrandet sind, eine Vielzahl von Abschirmgebieten des zweiten Dotierungstyps, die unterhalb der Gate-Elektroden angeordnet sind. Die Abschirmgebiete bilden unterhalb der Trenches miteinander einen Verbund der Abschirmgebiete, und mehrere Abschirmgebiete werden gemeinsam zu Anschlüssen für die Abschirmgebiete zur Kontaktierung geführt, wobei ein Gitter aus ersten Zellen gebildet ist, wobei die ersten Zellen aus dem Kanalanschluss des zweiten Dotierungstyps zur Kontaktierung der Kanalschicht und einen den Kanalanschluss umrandenden Source-Anschluss gebildet sind, wobei die ersten Zellen von den Trenches umrandet sind, wobei das Gitter Lücken aufweist, in die zweite Zellen eingelassen sind, die die Anschlüsse für die Abschirmgebiete zur Kontaktierung des Verbunds der Abschirmgebiete aufweisen. Die zweiten Zellen weisen weiterhin einen mit Source kurzgeschlossenen Diodenanschluss des zweiten Dotierungstyps auf, wodurch eine zum Transistor parallelgeschaltete integrierte Diode bereitgestellt wird, wobei die Diode an der Grenze zwischen der Kanalschicht und der Epitaxieschicht im Bereich der zweiten Zellen ausgebildet ist.

Der Begriff "mehrere Abschirmgebiete", die zusammen zu Anschlüssen geführt werden, umfasst mehr als zwei Abschirmgebiete, bevorzugt mehr als vier Abschirmgebiete, noch bevorzugter mehr als acht Abschirmgebiete.

Die Erfindung hat den Vorteil, dass die Kanalweite pro Fläche deutlich erhöht wird, das heißt, es erhöht sich die Stromtragfähigkeit des Transistors bei gleicher zur Verfügung gestellter Fläche, da die Kontaktierungsfläche durch den Verbund der Abschirmgebiete nicht mehr mal der Anzahl der Zellen sondern nur mal der Zahl der an die Oberfläche geführten Kontaktstellen sich vergrößert, wobei die Zahl der an die Oberfläche geführten Kontaktstellen durch den Verbund der Abschirmgebiete untereinander und die gemeinsame Führung zu den Anschlüssen erfindungsgemäß stets kleiner ist als die Zahl der Zellen. Entsprechend wird dadurch das Pitch-Maß des Transistors reduziert. Durch die sich ergebende Flächenreduzierung wird zudem eine Reduzierung der Kosten erzielt, da die Kosten pro Fläche ungefähr konstant sind.

Ein weiteres wichtiges Merkmal ergibt sich durch die ermöglichte Kontaktierung der Abschirmungsgebiete zur Abschirmung des elektrischen Feldes in Höhe der Trenches, wodurch höhere Schaltgeschwindigkeiten des Transistors erreicht werden können. Ferner wird zur Herstellung dieses Transistors keine Hochenergie-Implantation benötigt. Da ein Doppeltrench-Design hier vermieden wird, wie es im Stand der Technik häufig Verwendung findet, reduzieren sich technologische Aufwände, um beispielsweise Materialreste, wie zum Beispiel Gate-Material oder Isolationsmaterial aus den Trenches zu entfernen. Zusätzlich werden weitere Stufen und Kanten im Zellfeld vermieden, was die Reproduzierbarkeit verbessert, sowie die Justagegenauigkeit und die technischen Anforderungen an Lithographie gegenüber einem Doppeltrench-Design verringert.

Vorteilhaft können die Abschirmgebiete direkt unterhalb der Trenches angeordnet sein. Das bringt den Vorteil mit, dass der laterale Raumbedarf möglichst klein gehalten wird, das heißt, es wird wenig Zusatzfläche in Anspruch genommen.

Die Abschirmgebiete können innerhalb des Trenches als unterste Schicht eingelassen sein und durch eine erste Isolierschicht von der Gate-Elektrode isoliert sein. Das hat einen besonders effizienten und einfachen Herstellungsprozess zum Vorteil.

In einer besonderen Ausführungsform können die zweiten Zellen selbst ein Gitter innerhalb des Gitters der ersten Zellen bilden. Eine solche Struktur stellt ein Superlattice dar. Eine regelmäßige Struktur des Zellenfeldes ist gerade beim Herstellungsprozess von Vorteil und stabilisiert ferner den Betrieb. Auch hier kann die Größe der ersten Zellen und der zweiten Zellen variierbar sein und kann dem Bedarf an Stromtragfähigkeit angepasst werden.

Die zweiten Zellen weisen einen mit Source kurzgeschlossenen Diodenanschluss auf, wodurch eine parallelgeschaltete integrierte Diode bereitgestellt wird. Für viele Schaltapplikationen wird eine solche Diode vorteilhaft benötigt. Die Fläche für den Anschluss der integrierten Diode kann in Kombination mit der zu erzielenden Stromtragfähigkeit variierbar eingestellt werden.

Vorteilhaft kann die Anzahl der zweiten Zellen kleiner sein als die Anzahl der ersten Zellen und/oder die Anzahl der Anschlüsse der Abschirmgebiete kleiner sein als die Anzahl der Kanalanschlüsse. Der Flächengewinn wird dadurch größer, da die Stromtragfähigkeit über die ersten Zellen realisiert beziehungsweise erwirtschaftet wird.

Die zweiten Zellen können eine größere Fläche aufweisen als die ersten Zellen. Das hat den Vorteil, dass die Fläche für den Diodenanschluss größer ausgebildet werden kann.

Der Flächenanteil der zweiten Zellen kann weniger als 30%, bevorzugt weniger als 10% der Gesamtfläche des Transistors ausmachen. Dadurch wird eine erhöhte Stromtragfähigkeit gegenüber den herkömmlichen Methoden des Standes der Technik besonders sichergestellt.

Vorteilhaft können die zweiten Zellen und/oder die ersten Zellen dreieckig, rechteckig, quadratisch, fünfeckig, sechseckig, rund oder linienförmig ausgebildet sein.

Bevorzugt ist der Transistor ein TrenchMOSFET-Transistor.

### Zeichnungen

Ausführungsbeispiele der Erfindung werden anhand der Zeichnungen und der nachfolgenden Beschreibung näher erläutert. Es zeigen:
Figur 1 ein erfindungsgemäßer Transistor als Seitenansicht gemäß einem ersten Ausführungsbeispiel,
Figur 2 ein Zellenfeld mit sichtbarem Verbund der Abschirmgebiete mit Superlattice-Struktur als Draufsicht,
Figur 3 ein Zellenfeld mit unbefüllten Trenches als Draufsicht,
Figur 4 ein Zellenfeld mit eingebrachten Gate-Elektroden als Draufsicht,
Figur 5 ein Zellenfeld mit eingebrachter erster Isolationsschicht als Draufsicht,
Figur 6 eine Superlattice-Struktur, und
Figur 7 ein Transistor als Seitenansicht zum technischen Verständnis.

### Ausführungsformen der Erfindung

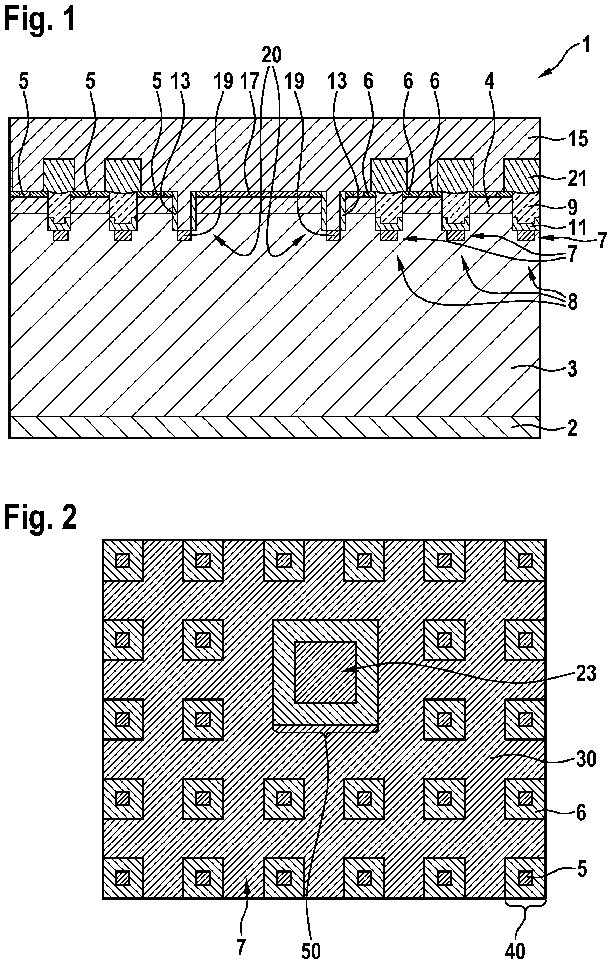

In der Figur 1 ist ein erfindungsgemäßer Transistor 1, beispielhaft ein TrenchMOSFET-Transistor 1 als Seitenansicht gemäß einem ersten Ausführungsbeispiel gezeigt. Der Transistor 1 zeigt eine Schichtfolge aus einem Halbleitermaterial, bevorzugt aus Siliciumcarbid (SiC). Die unterste Schicht wird durch ein Substrat 2 eines ersten Dotierungstyps gebildet, das typischerweise als Drain-Anschluss fungiert (metallischer Kontakt nicht eingezeichnet). Es folgt eine Epitaxieschicht 3 des ersten Dotierungstyps und eine oberhalb dieser Epitaxieschicht 3 angelegte Kanalschicht 4 eines zweiten Dotierungstyps, der vom ersten Dotierungstyp verschieden ist.

Ferner ist eine Vielzahl von Trenches 8 durch die Kanalschicht 4 bis in die Epitaxieschicht 3 eingelassen. In diesen Trenches 8 befindet sich eine Gate-Elektrode 9, die eigenständig kontaktiert werden kann. Die Gate-Elektrode 9 ist ummantelt von einem Gate-Isolator (nicht eingezeichnet), der die Gate-Elektrode 9 von der Umgebung elektrisch isoliert. Als Gate-Isolator wird typischerweise ein Oxid verwendet. Typischerweise wird als Gate-Material dabei Polysilicium verwendet, wobei auch alternativ Metalle, wie beispielsweise Aluminium, verwendet werden können. Oberhalb der Kanalschicht 4 befindet sich ein jeden Trench 8 umrandender Source-Anschluss 6 des ersten Dotierungstyps. Es sind Abschirmgebiete 7 des zweiten Dotierungstyps unterhalb der Trenches 8 angeordnet, die den Gate-Isolator vor zu hohen elektrischen Feldern abschirmen. Diese Abschirmgebiete 7 bilden erfindungsgemäß einen Verbund 30 der Abschirmgebiete untereinander unterhalb der Trenches 8, vorzugsweise als zweidimensionale Netzwerkstruktur (in dieser Ansicht nicht sichtbar, in Folge in Figur 2 bei Draufsicht sichtbar) ausgeführt, wobei die Erfindung nicht auf ein zweidimensionales Verbindungssystem beschränkt ist.

Ferner zeigt Figur 1 erfindungsgemäß gemeinsam an die Oberfläche geführte Anschlüsse 19 für die Abschirmgebiete des zweiten Dotierungstyps. Erfindungsgemäß werden diese Anschlüsse 19 für die Abschirmgebiete folglich nicht an jedem Trench 8 realisiert, sondern nur an bestimmten Stellen, was durch den erfinderischen Verbund 30 der Abschirmgebiete unterhalb der Trenches 8 ermöglicht wird. Die Anschlüsse 19 für die Abschirmgebiete sind beispielhaft innerhalb schmaler Gräben 20 ausgeführt, seitlich mit einer zweiten Isolierschicht 13 vor der Kanalschicht 4 und der Epitaxieschicht 3 isoliert und über ein Metall 15 mit dem Source-Anschluss 6 verbunden. Die Gräben 20 sind dabei beispielhaft so tief angelegt, dass der Anschluss 19 der Abschirmgebiete auf gleicher Höhe mit den Abschirmgebieten 7 unterhalb der Trenches 8 liegt. Durch die erfindungsgemäße Reduzierung der Anschlüsse 19 für die Abschirmgebiete wird der Flächenbedarf vorteilhaft reduziert, was zu einer Reduzierung des Pitch-Maßes führt und die Stromtragfähigkeit des Transistors 1 bei gleicher Fläche gegenüber dem Stand der Technik erhöht. Die Abschirmgebiete 7 können beispielsweise als sogenannte Bubbles des zweiten Dotierungstyps ausgeführt werden, oder aber alternativ auch durch eine effektive Kompensationsschicht des zweiten Dotierungstyps, bestehend aus periodisch angeordneten alternierenden Gebieten des ersten und zweiten Dotierungstyps. Die Position des Abschirmgebiets 7 muss nicht unmittelbar unterhalb des Trenches 8 liegen, sondern kann alternativ auch versetzt sein oder zum Beispiel den unteren Teil des Trenches 8 ummantelnd angeordnet sein. Auch die Form des Abschirmgebiets 7 unterhalb der Trenches 8 kann variabel sein, beispielsweise rund oder ellipsoidartig. Zwischen den Abschirmgebieten 8 und der Gate-Elektrode 9 kann eine zusätzliche verdickende erste Isolierschicht 11 eingebracht sein, um die Gate-Elektrode 9 verstärkt zu isolieren.

Die Kanalanschlüsse 5 des zweiten Dotierungstyps werden von Source-Anschlüsse 6 umrahmt, welche der Kontaktierung der Kanalschicht 4 dienen. Die Kontaktierung ist über das Metall 15 mit dem Source-Anschluss 6 verbunden. Oberhalb der Gate-Elektrode 9 befindet sich eine dritte Isolierschicht 21, die die Gate-Elektrode 9 vollständig vom Metall 15 isoliert. In dieser Ausführungsform ist ein Diodenanschluss 17 des zweiten Dotierungstyps, hier beispielhaft zwischen zwei Gräben 20 für die Anschlüsse 19 für die Abschirmgebiete ausgeführt. Der Diodenanschluss 17 ist hier entsprechend mit dem Source-Anschluss 6 über das Metall 15 angeschlossen und liefert somit eine integrierte parallelgeschaltete Diode, die für verschiedenste Schaltapplikationen vorteilhaft Verwendung finden kann.

Die Funktionsweise des Transistors 1 folgt dabei dem üblichen Standard und ist hier nur zum ferneren Verständnis hinzugefügt. Bei positiver (negativer) Spannung an der Gate-Elektrode 9 bei npn-Schichtfolge (pnp), die größer als eine Schwellenspannung sei, wird ein dünner durchgehender Kanal (Inversionskanal) in der Kanalschicht 4 entlang der Seitenwände der Trenches 8 erzeugt, der in die Epitaxieschicht 3 reicht und eine leitende Verbindung zwischen Substrat 2 und Source-Anschluss 6 ausbildet. Entlang dieser Kanäle kann dann Strom fließen, wenn entsprechend eine Spannung zwischen Drain und Source angelegt wird. Weiteres ist der einschlägigen Fachliteratur zu entnehmen.

Figur 2 zeigt einen Schnitt durch den Transistor 1, bei dem die eingelassenen Abschirmgebiete 7 sichtbar sind. Es zeigt sich eine zellenartige Struktur. Eine erste Zelle 40 besteht beispielhaft aus dem Kanalanschluss 5 des zweiten Dotierungstyps sowie aus dem benachbarten Source-Anschluss 6. Diese ersten Zellen 40 sind voneinander getrennt durch die Abschirmgebiete 7 des elektrischen Feldes vom Trench 8, die einen erfindungsgemäßen Verbund 30 der Abschirmgebiete bilden, hier beispielhaft ein regelmäßiges Netzwerk, wobei die Erfindung nicht auf einen regelmäßigen Strukturverbund beschränkt ist. Die ersten Zellen 40 sind beispielhaft quadratisch ausgeführt, können aber auch rechteckig, dreieckig, fünfeckig, sechseckig, rund, linienförmig etc. sein. Die ersten Zellen 40 bilden hier beispielhaft zwischen dem Verbund 30 der Abschirmgebiete ein Gitter. Dieses Gitter weist in dieser Figur eine Lücke auf, in die eine zweite Zelle 50 eingelassen ist.

Die zweite Zelle 50 besteht aus einem gemeinsamen Anschluss 23 sowohl für die Abschirmgebiete 7 als auch für die parallelgeschaltete Diode. Wie in Figur 1 können diese Kontakte auch separat ausgeführt sein. Dieser Kontakt ist entsprechend verbunden (nicht aus dieser Perspektive ersichtlich) mit dem Verbund 30 der Abschirmgebiete. Der unterhalb der Trenches 8 lokalisierte Verbund 30 der Abschirmgebiete wird gemäß der Erfindung nur an den zweiten Zellen 50 an die Oberfläche zur Kontaktierung geführt. Dadurch wird entsprechend Fläche eingespart, da der laterale Raumbedarf reduziert wird, und die Stromtragfähigkeit pro Fläche erhöht.

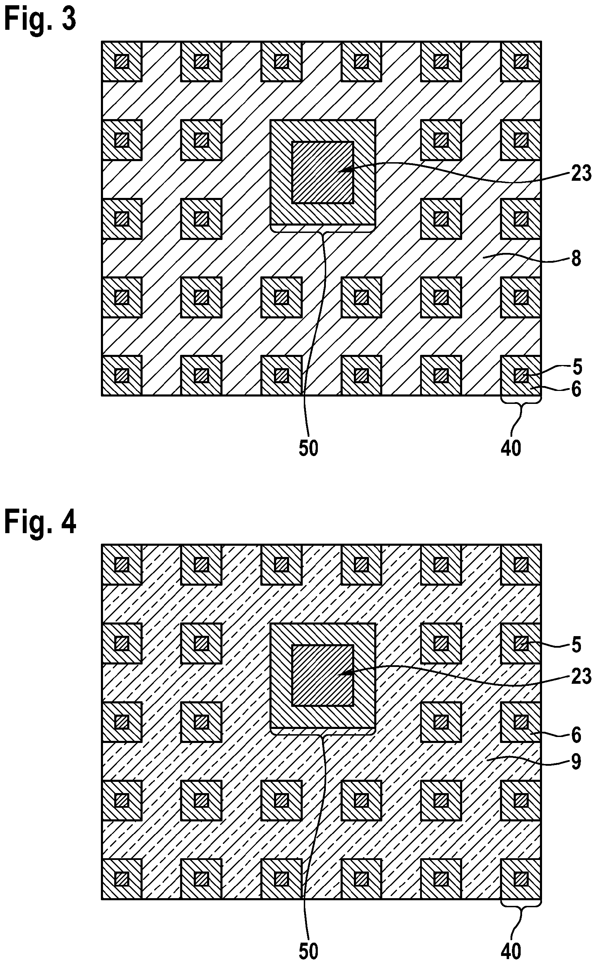

Figur 3 zeigt einen Schnitt durch den Transistor 1, allerdings im Präparationsschritt mit noch nicht befüllten Trenches 8. Die Trenches 8 bilden hier ein verbundenes Netzwerk, in das die Abschirmgebiete 7 als unterste Schicht eingelassen werden können nach Figur 2. Die Erfindung schließt aber auch den Fall ein, dass die Trenches 8 unverbunden sind und damit selbst die ersten Zellen 40 des Zellenfeldes bilden.

Figur 4 zeigt ebenso wie Figur 2 und 3 das Zellenfeld, dabei sind die Gate-Elektroden 9 eingebracht, die sich oberhalb des Verbunds 30 der Abschirmgebiete befindet. Die zweiten Zellen 50 weisen beispielhaft einen gemeinsamen Anschluss 23 sowohl für die Abschirmgebiete 7 als auch für die parallelgeschaltete Diode auf.

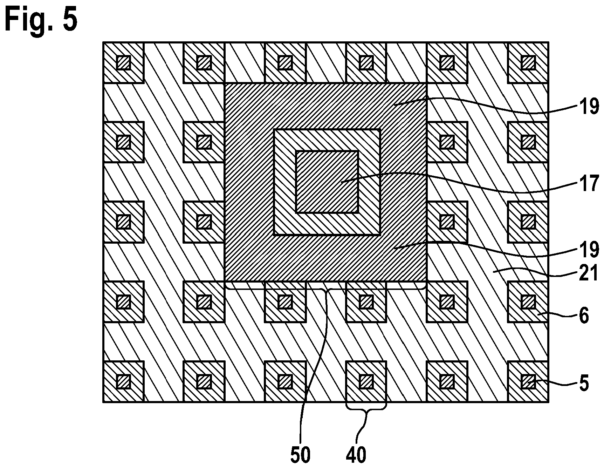

Figur 5 zeigt ein Zellenfeld, in das oberhalb der Gate-Elektrode 9 eine dritte Isolierschicht 21 aufgetragen ist, die die Gate-Elektrode 9 von der Umgebung isoliert. Ferner sind in der zweiten Zelle 50 ein Anschluss 19 für Abschirmgebiete integriert, hier beispielhaft am Rand der zweiten Zelle 50 ausgeführt, sowie der Diodenanschluss 17, hier beispielhaft im Inneren der zweiten Zelle 50 ausgeführt.

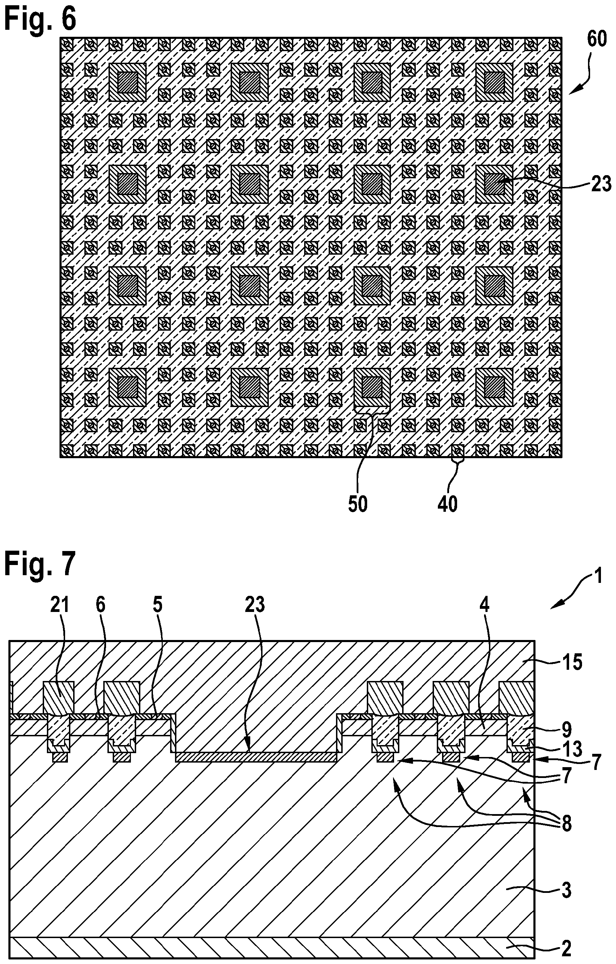

Figur 6 zeigt ein Zellenfeld eines Transistors 1 mit mehreren zweiten Zellen 50. Die Gesamtheit der ersten Zellen 40 bildet ein Gitter, das Lücken aufweist, in die die zweiten Zellen 50 eingelassen sind. Die zweiten Zellen 50 bilden dabei selbst ein Gitter, ein Superlattice 60. Diese weisen beispielhaft einen gemeinsamen Anschluss 23 sowohl für die Abschirmgebiete 7 als auch für die Diode auf. Die Erfindung ist dabei aber nicht auf ein Superlattice 60 beschränkt. Zum Beispiel können die zweiten Zellen 50 auch ungeordnet im Zellenfeld der ersten Zellen 40 verteilt sein, oder nur eine einzige zweite Zelle 50 ist als Kontakt für die integrierte parallelgeschaltete Diode oder als Anschluss 19 für die Abschirmgebiete 7 zuständig. Die Zellen sind hierbei beispielhaft als Quadrate ausgeführt. Die Erfindung ist aber nicht auf diese Art von Zellen beschränkt, sondern es können auch Dreiecke, Rechtecke, Fünfecke, Sechsecke etc. verwendet werden. Ebenso kann die Anordnung der zweiten Zellen 50 und/oder ersten Zellen 40, eine andere Struktur aufweisen als die in diesem Fall ausgeführte Quadratgitterstruktur, sprich beispielsweise rechteckig, dreieckig, fünfeckig, sechseckig, etc.

Die Gittertypen von ersten Zellen 40 und zweiten Zellen 50 müssen zudem nicht gleich sein. Die in dem Ausführungsbeispiel gewählte quadratische Struktur hat den Vorteil, dass sie einen besonders einfachen und schnellen Herstellungsprozess ermöglicht.

Figur 7 zeigt zum technischen Verständnis einen Transistors 1 als Seitenansicht ähnlich zu Figur 1, jedoch ohne parallelgeschaltete Diode. Anders als in Figur 1 ist hier der dort gezeigte Diodenanschluss 17 mit dem Anschluss 19 für die Abschirmgebiete zu einem gemeinsamen Anschluss 23 zusammengelegt und gemeinsam abgesenkt. Die Tiefe dieser Anschlüsse entspricht hier bespielhaft der Tiefe der Abschirmgebiete 7.

Die Erfindung hat den Vorteil, dass bei gleicher Fläche eine erhöhte Stromtragfähigkeit gewährleistet wird, durch die eine Reduzierung der Anschlüsse für die Abschirmgebiete 19 erzielt wird. Der Kern der Erfindung ist dabei der Verbund 30 der Abschirmgebiete unterhalb der Trenches, wodurch nicht mehr an jedem Trench eine Kontaktstelle an die Oberfläche geführt werden muss. Ferner werden in einer bestimmten Ausführungsform regelmäßige Zellstrukturen mit sowohl einem Gitter aus ersten Zellen 40 als auch einem überlagerten Gitter aus zweiten Zellen 50 vorgeschlagen, die den Vorteil einer einfachen Herstellung sowie einen stabilen Betrieb aufweisen.

Obwohl die Erfindung im Detail durch bevorzugte Ausführungsbeispiele näher illustriert und beschrieben wurde, so ist die Erfindung nicht durch die offenbarten Beispiele eingeschränkt, und andere Variationen können vom Fachmann hieraus abgeleitet werden, ohne den Schutzumfang der Erfindung zu verlassen.

## Patentansprüche

1. Transistor (1) umfassend:
ein Substrat (2) eines ersten Dotierungstyps;
eine Epitaxieschicht (3) des ersten Dotierungstyps oberhalb des Substrats (2);
eine Kanalschicht (4) eines zweiten, vom ersten verschiedenen Dotierungstyps oberhalb der Epitaxieschicht (3);
eine Vielzahl von sich bis in die Epitaxieschicht (3) erstreckenden Trenches (8) in der Kanalschicht (4), die jeweils eine innerhalb der Trenches (8) befindliche Gate-Elektrode (9) aufweisen und von einem Source-Anschluss (6) des ersten Dotierungstyps oberhalb der Kanalschicht (4) umrandet sind;
eine Vielzahl von Abschirmgebieten (7) des zweiten Dotierungstyps, die unterhalb der Gate-Elektroden (9) angeordnet sind;
wobei die Abschirmgebiete (7) unterhalb der Trenches (8) miteinander einen Verbund (30) der Abschirmgebiete (7) bilden und mehrere Abschirmgebiete (7) gemeinsam zu Anschlüssen (19) für die Abschirmgebiete (7) zur Kontaktierung geführt sind;
wobei ein Gitter aus ersten Zellen (40) gebildet ist, wobei die ersten Zellen (40) aus dem Kanalanschluss (5) des zweiten Dotierungstyps zur Kontaktierung der Kanalschicht (4) und einen den Kanalanschluss (5) umrandenden Source-Anschluss (6) gebildet sind, wobei die ersten Zellen (40) von den Trenches (8) umrandet sind, wobei das Gitter Lücken aufweist, in die zweite Zellen (50) eingelassen sind, die die Anschlüsse (19) für die Abschirmgebiete zur Kontaktierung des Verbunds (30) der Abschirmgebiete aufweisen; wobei
die zweiten Zellen (50) einen mit Source kurzgeschlossenen Diodenanschluss (17) des zweiten Dotierungstyps aufweisen, wodurch eine zum Transistor (1) parallelgeschaltete integrierte Diode bereitgestellt ist, wobei die Diode an der Grenze zwischen der Kanalschicht (4) und der Epitaxieschicht (3) im Bereich der zweiten Zellen (50) ausgebildet ist.

2. Transistor (1) nach Anspruch 1, wobei die Abschirmgebiete (7) direkt unterhalb der Trenches (8) angeordnet sind.

3. Transistor (1) nach einem der vorigen Ansprüche 1 oder 2, wobei die Abschirmgebiete (7) innerhalb des Trenches (8) als unterste Schicht eingelassen sind und durch eine erste Isolierschicht (11) von der Gate-Elektrode (9) isoliert sind.

4. Transistor (1) nach einem der vorigen Ansprüche , wobei die zweiten Zellen (50) selbst ein Gitter (60) innerhalb des Gitters der ersten Zellen (40) bilden.

5. Transistor (1) nach einem der vorigen Ansprüche, wobei die Anzahl der zweiten Zellen (50) kleiner ist als die Anzahl der ersten Zellen (40) und/oder die Anzahl der Anschlüsse (19) der Abschirmgebiete (7) kleiner ist als die Anzahl der Kanalanschlüsse (5).

6. Transistor (1) nach einem der vorigen Ansprüche, wobei die zweiten Zellen (50) eine größere Fläche aufweisen als die ersten Zellen (40).

7. Transistor (1) nach einem der vorigen Ansprüche, wobei der Flächenanteil der zweiten Zellen (50) weniger als 30%, bevorzugt weniger als 10% der Gesamtfläche des Transistors (1) ausmacht.

8. Transistor (1) nach einem der vorigen Ansprüche, wobei die zweiten Zellen (50) und/oder die ersten Zellen (40) dreieckig, rechteckig, quadratisch, fünfeckig, sechseckig, rund oder linienförmig ausgebildet sind.

9. Transistor (1) nach einem der vorigen Ansprüche, wobei der Transistor (1) ein TrenchMOSFET-Transistor ist.

## Claims

1. Transistor (1) comprising:
a substate (2) of a first doping type;
an epitaxial layer (3) of the first doping type above the substrate (2);
a channel layer (4) of a second doping type, different from the first doping type, above the epitaxial layer (3) ;
a multiplicity of trenches (8) in the channel layer (4) which extend into the epitaxial layer (3), each have a gate electrode (9) situated within the trenches (8) and are surrounded by a source terminal (6) of the first doping type above the channel layer (4);
a multiplicity of screening regions (7) of the second doping type, which are arranged below the gate electrodes (9) ;
wherein the screening regions (7) below the trenches (8) form with one another a group (30) of screening regions (7) and a plurality of screening regions (7) are together routed to terminals (19) for the screening regions (7) for contact-connection;
wherein a lattice is formed from first cells (40), wherein the first cells (40) are formed from the channel terminal (5) of the second doping type for contact-connecting the channel layer (4) and a source terminal (6) surrounding the channel terminal (5), wherein the first cells (40) are surrounded by the trenches (8), wherein the lattice has gaps in which second cells (50) are embedded, said second cells having the terminals (19) for the screening regions for contact-connecting the group (30) of screening regions;
wherein the second cells (50) have a diode terminal (17) of the second doping type which is short-circuited to the source, as a result of which an integrated diode connected in parallel with the transistor (1) is provided, wherein the diode is formed at the boundary between the channel layer (4) and the epitaxial layer (3) in the region of the second cells (50).

2. Transistor (1) according to Claim 1, wherein the screening regions (7) are arranged directly below the trenches (8).

3. Transistor (1) according to either of preceding Claims 1 and 2, wherein the screening regions (7) are embedded within the trench (8) as the lowermost layer and are insulated from the gate electrode (9) by a first insulating layer (11).

4. Transistor (1) according to one of the preceding claims, wherein the second cells (50) themselves form a lattice (60) within the lattice of the first cells (40).

5. Transistor (1) according to one of the preceding claims, wherein the number of second cells (50) is less than the number of first cells (40) and/or the number of terminals (19) of the screening regions (7) is less than the number of channel terminals (5).

6. Transistor (1) according to one of the preceding claims, wherein the second cells (50) have a larger area than the first cells (40).

7. Transistor (1) according to one of the preceding claims, wherein the area proportion of the second cells (50) makes up less than 30%, preferably less than 10%, of the total area of the transistor (1).

8. Transistor (1) according to one of the preceding claims, wherein the second cells (50) and/or the first cells (40) are in triangular, rectangular, square, pentagonal, hexagonal, round or linear form.

9. Transistor (1) according to one of the preceding claims, wherein the transistor (1) is a trench MOSFET transistor.

## Revendications

1. Transistor (1) comprenant :
un substrat (2) d'un premier type de dopage ;
une couche épitaxiale (3) du premier type de dopage au-dessus du substrat (2) ;
une couche de canal (4) d'un deuxième type de dopage, différent du premier, au-dessus de la couche épitaxiale (3) ;
un grand nombre de tranchées (8) qui sont ménagées dans la couche de canal (4), qui s'étendent jusque dans la couche épitaxiale (3), qui comportent chacune une électrode de grille (9) située à l'intérieur des tranchées (8) et qui sont bordées par une borne de source (6) du premier type de dopage au-dessus de la couche de canal (4) ;
un grand nombre de régions de blindage (7) du deuxième type de dopage qui sont disposées au-dessous des électrodes de grille (9) ;
les régions de blindage (7) formant au-dessous des tranchées (8) un composite (30) de régions de blindage (7) et une pluralité de régions de blindage (7) étant amenées conjointement en contact avec des bornes (19) destinées aux régions de blindage (7) ;
une grille étant formée à partir de premières cellules (40), les premières cellules (40) étant formées à partir de la borne de canal (5) du deuxième type de dopage pour contacter la couche de canal (4) et d'une borne de source (6) bordant la borne de canal (5), les premières cellules (40) étant bordées par les tranchées (8), la grille comportant des espaces dans lesquels sont encastrées des deuxièmes cellules (50) qui comportent les bornes (19) destinées aux régions de blindage destinées à contacter le composite (30) de régions de blindage ;
les deuxièmes cellules (50) comportant une borne de diode (17) du deuxième type de dopage qui est court-circuitée à la source, ce qui donne une diode intégrée montée en parallèle avec le transistor (1),
la diode étant formée à la frontière entre la couche de canal (4) et la couche épitaxiale (3) dans la zone des deuxièmes cellules (50).

2. Transistor (1) selon la revendication 1, les régions de blindage (7) étant disposées directement au-dessous des tranchées (8).

3. Transistor (1) selon l'une des revendications 1 ou 2 précédentes, les régions de blindage (7) étant encastrées dans la tranchée (8) en tant que couche inférieure et étant isolées de l'électrode de grille (9) par une première couche isolante (11).

4. Transistor (1) selon l'une des revendications précédentes, les deuxièmes cellules (50) formant elles-mêmes une grille (60) à l'intérieur de la grille des premières cellules (40).

5. Transistor (1) selon l'une des revendications précédentes, le nombre de deuxièmes cellules (50) étant inférieur au nombre de premières cellules (40) et/ou le nombre de bornes (19) des régions de blindage (7) étant inférieur au nombre de bornes de canal (5).

6. Transistor (1) selon l'une des revendications précédentes, les deuxièmes cellules (50) ayant une plus grande surface que les premières cellules (40).

7. Transistor (1) selon l'une des revendications précédentes, la surface des deuxièmes cellules (50) représentant moins de 30 %, de préférence moins de 10 %, de la surface totale du transistor (1).

8. Transistor (1) selon l'une des revendications précédentes, les deuxièmes cellules (50) et/ou les premières cellules (40) étant triangulaires, rectangulaires, carrées, pentagonales, hexagonales, rondes ou linéaires.

9. Transistor (1) selon l'une des revendications précédentes, le transistor (1) étant un transistor MOSFET à tranchées.
